# EUROPEAN PATENT SPECIFICATION

(11) **EP 0 289 145 B1**
(45) Date of publication and mention of the grant of the patent: **12.01.1994**
(21) Application number: 88302904.3
(22) Date of filing: 31.03.1988
(51) Int. Cl.: G01R 31/28, G06F 11/22, G06F 11/26

(54) **Self-learn method for circuit tester**
Selbstlernmethode für Schaltungstester
Méthode d'auto-apprentissage pour testeur de circuit

(30) Priority: 27.04.1987 GB 8709915
(43) Date of publication of application: 02.11.1988
(73) Proprietor: MARCONI INSTRUMENTS LIMITED, St. Albans Hertfordshire, AL4 0JN (GB)
(72) Inventor: Matheson, Robert William, St Albans Hertfordshire (GB)
(74) Representative: Tolfree, Roger Keith

(56) References cited:
- US-A- 4 114 093
- US-A- 4 550 406

## Description

This invention relates to test equipment and in particular but not exclusively it relates to test equipment in the form of manufacturing defect analysers (MDA's) for testing printed circuit boards.

Manufacturing defect analysers are commonly used for pre-screening printed circuit boards to identify manufacturing defects such as short and open circuits; missing, wrong or mis-orientated components. They can also be used as fast analog in-circuit testers in environments where high accuracey is not required. Traditional methods of testing boards using MDA's involve a test program embodied in the MDA which tests each component on a board in isolation, using standard guarding techniques to isolate the effects of surrounding components. This produces a very high standard of test program but since a separate program must be written for each individual board or type of board to be tested a skilled programmer is required and a great deal of effort and time is expended. Furthermore the MDA cannot easily be used by unskilled personnel.

In order to overcome these limitations several MDA's are now provided which include a self learn facility. This self-learn facility involves the MDA learning an impedance pattern for a known good board. Subsequent testing of production boards compares the impedance pattern of the board against that of the known good board and produces a fault signal if there are any differences. Several different methods have been used for learning and testing impedances, giving varying degrees of fault coverage. Often, one or more reference nodes such as power rails are chosen in a known good board and the impedance is measured from the reference node to each other node on the circuit. However, since all the methods merely measure the impedance between any two nodes then it effectively combines the effects of a number of components in parallel or series and hence failures of some components are not detected since their effect on the impedance between two points may be minimal. Thus, the failure of some components may not be detected by the system and, when a board has failed the test, location of the specific component causing the fault is difficult.

A self-learn, in-circuit testing system is described in US 4,550,406. In this system, a number of nodes of the circuit to be tested are specifically designated "common nodes" and a number are designated "adjacent nodes". The bulk of the testing is carried out between the common nodes, i.e. those to which many of the components on the board are connected, and other nodes relating to components connected to the common nodes. Isolated components are counted as having adjacent nodes and are tested separately. The system relies for its operation on the appropriate designation of the two types of node by the test personnel.

According to the present invention there is provided a self-learn method for a circuit tester comprising the steps of setting every node of a circuit to a common potential; removing the common potential from a first chosen stimulus node and applying a stimulus voltage to said first chosen stimulus node and removing the common potential from a second chosen test node; monitoring the voltage developed on the second chosen test node; identifying the presence of a component between the first and second nodes by means of the variation of the voltage developed at the second chosen test node with time, and repeating the process for at least a portion of all pairs of nodes on the circuit.

Advantageously, each node on the circuit is tested against each other node, using each node as a stimulus and a test node. The common potential will generally be ground potential.

Preferably, the voltage developed on the second test node is compared against a chosen threshold value. If, within a specified time, the voltage crosses the threshold value then a component is identified between the stimulus and test nodes. The exact nature of the component can then be determined by monitoring the way in which the voltage crosses the threshold, or by conducting standard tests for components, as will be further described below; thus components such as resistors, capacitors, diodes and inductors can be identified.

Before applying the stimulus voltage, the stim and test nodes are preferably discharged so as to remove any residual charge present from a previous test.

Typically, the stimulus is of one volt and the threshold value is 20 millivolts.

The monitoring time can be limited, for example to 100 microseconds and the measurement can be automatically terminated before this time expires if the measured voltage crosses the threshold value, thus reducing the time needed to apply the technique to a whole circuit board.

The process is repeated until every node has been tested against every other node using each node as a stim and test node. By using each pair of nodes twice, i.e. using each as a stim and test node, components such as diodes can be identified which have differential characteristics depending upon the direction of applied voltage.

Embodiments of the present invention will now be described by way of example only with reference to the accompanying drawings in which:
Figure 1 shows the result of applying the technique according to the invention between two nodes having a resistor between them.
Figure 2 shows the results of having a capacitor between two nodes.
Figure 3 shows the results of having a diode between two nodes.
Figure 4 shows the results of having an inductor between two nodes and
Figure 5 shows a schematic outline of the self-learn technique.

In use of a self-learn method according to the present invention, a known good board is taken and its connectivity information, i.e. the short and open circuits, if any, are learnt by any convenient method. Every node on the board is then grounded. The system then proceeds to make a series of tests for each node on the board, and a stimulus circuit is connected to each node under consideration in turn. The stimulus circuit can be any circuit for applying a voltage to that node.

A first test node is chosen and both the stimulus (stim) node and test node are discharged to remove any residual charge present from a previous test. A stimulus voltage is then applied to the stim node and the ground is removed from the test node. The voltage developed from the test node is then monitored, relative to ground, during a measurement gate period of typically 100 microseconds, and is compared against a programmed threshold value, typically 20 millivolts. If the measured voltage on the test node crosses the threshold value during the measurement gate period then a component is identified between the two nodes and the test is automatically terminated. If the threshold is not crossed within the measurement gate period then it can be assumed that there is no component between the two nodes. Of course, by "no component" is meant that there is no component directly between the two nodes although of course there may still be other components indirectly between the two nodes having other nodes between them. The effect of such other component will be substantially eliminated since the intermediate nodes are grounded. Retaining the same stimulus node, a second test node is chosen and the technique repeated. It is subsequently repeated for each node in turn using the same stimulus node and then the next stimulus node is chosen and the process repeated, eventually using all nodes as the stimulus and test nodes.

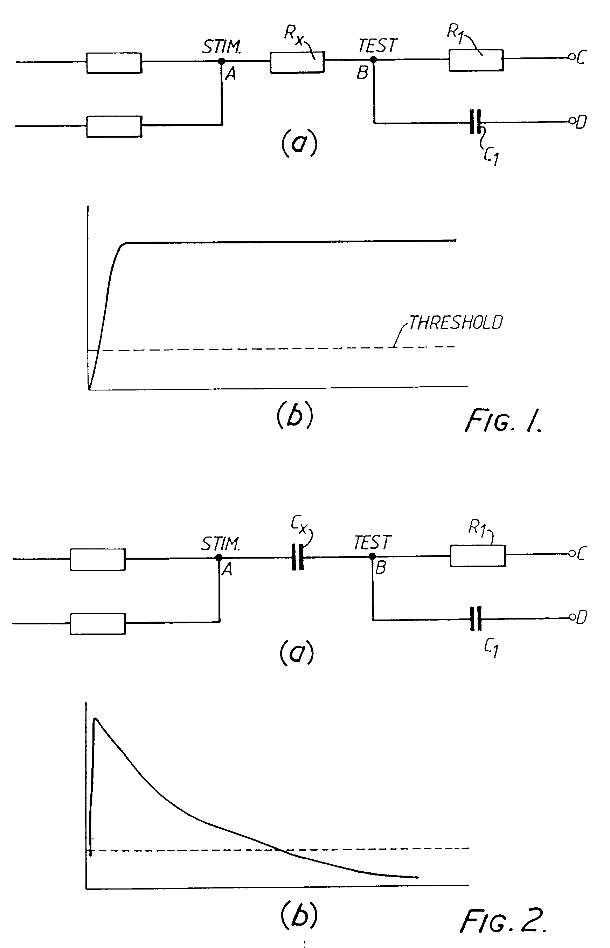

Referring to Figure 1a, node A is used as the stimulus node and node B as the test node, there being a resistor Rₓ between nodes A and B. All other nodes in the circuit, including node C and D are grounded. When the stimulus voltage is applied to node A and the grounding removed from node B, the voltage developed at node B will be as shown in Figure 1b. The voltage rapidly increases at node B and reaches a steady value dependent upon the value of the resistor, providing the threshold value is set low enough then it will quickly be exceeded by the developing voltage. Thus a resistive component is identified between nodes A and B.

Referring again to Figure 1, if node A is again used as the stim node and node C is this time used as a test node, with node B being grounded, then it is seen that no voltage will be developed at node C since the path between A and C has a grounded node in it. Hence, the system would learn that there is an intermediate node between nodes A and C. A similar consideration applies to node D and so on.

Referring now to Figure 2a, the resistor Rₓ has been replaced by a capacitor Cₓ. Applying a similar test, the voltage developed at node B would be generally that shown in Figure 2b where it is seen that the voltage rapidly increases to a maximum value then slowly decreases until at a steady state dc value no voltage is present at node B. Hence, the voltage developed first exceeds the threshold value then eventually becomes less than it. This threshold crossing serves to reveal the presence of the component.

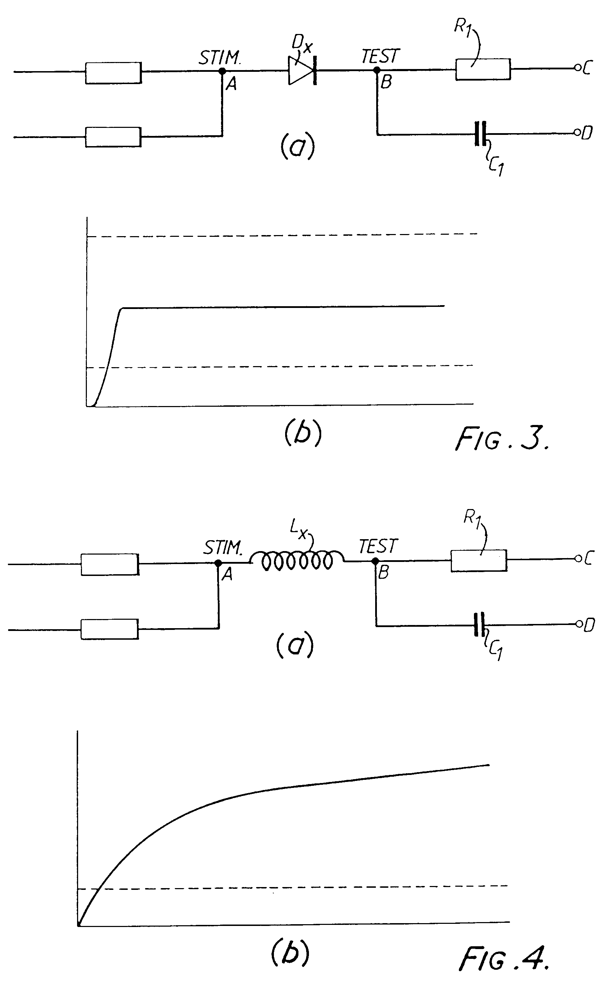

In Figure 3a a diode Dₓ is placed between nodes A and B. In this case a developed voltage is as shown in Figure 3b although it will depend upon the type of diode present. The voltage rises to a value depending on the value of resistor R1 and also the current available and will generally be sufficient to cross the threshold voltage unless R1 is an extremely low value. It should be noted that when the reverse test is applied, i.e. applying a stimulus to node B and using node A as the test node then no component will be found since the diode will be reverse biased and therefore non conducting.

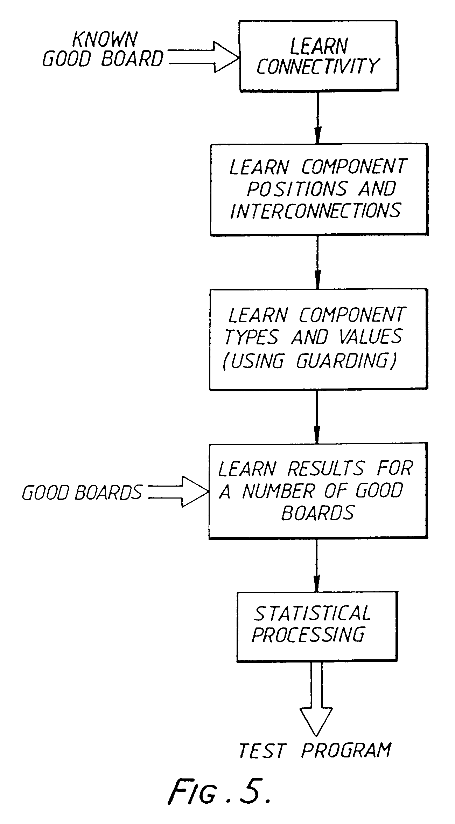

Figure 4a shows a circuit with an inductor Lₓ between nodes A and B. In such a case application of a stimulus voltage to node A and removing the ground from node B will produce the voltage characteristic shown in Figure 4b which is smaller to that of a resistor but will be much shallower curve due to the induced currents in the inductor Lx.

Integrated circuits (ic's) can generally also be identified by the method since most integrated circuits have some form of characteristic impedance or semiconductor junction between at least some of their pins. If such characteristics exist, the self-learn technique will find them since it treats each pin as a separate node and will measure their value, thus checking that the ic is present and correctly orientated.

As described above, the presence of a component between two nodes is revealed by the monitored voltage crossing the threshold value. Having identified pairs of nodes between which components have been found, the test system proceeds to learn each components type and value. Known techniques can be used for this. To test capacitors and resistors for example, the system also uses guarding techniques, as are well known in the art, to attempt to isolate the effect of surrounding components. As the system knows of the position of each component, it uses the information on each other component connected to either of the nodes under test and attempts to guard the node at the opposite end of each of these components. For each such guard point, the measurement is checked to see if the guard has improved the measured value and, if so, it is retained as a guard node. Auto-ranging techniques can be applied in which various component values are tried until the correct value is identified. To test whether a semi-conductor junction is present a simple on/off test in each direction indicates whether a diode exists and, if so, its orientation. The special case of two parallel but reversed diodes can also be detected.

When the testing of one good board has been completed, the test system preferably repeats the learning process with a plurality of such boards and averages out the values obtained to provide an indication of the spread of values which can be measured for each component. These can be used to determine the limits of the test to be incuded in the eventual test programme, although a minimum tolerance is also normally applied. Some tests, such as those for impedences of ic's whose characteristics may vary widely between different manufacturers or batches, can be rejected if the test gives a too wide spread of results.

The complete learning process is shown schematically in Figure 5.

After the test program has been fully developed as described above it is a simple matter to apply it to the subsequent testing of unknown boards and it can be further edited or developed as required.

It is possible to add component identifiers into the test programme to enable the test system to report faulty components in terms of their component identifier. A component identifier is a label, unique to each component and allowing identification of that component. The provision of component identifiers is a useful diagnostic capability. To enable the test system this facility, the user must enter the node information relating to each component identifier, such as each unique resistor, capacitor etc. For analog components, this information will generally be 2 or 3 nodes while for ic's the number of nodes may be large. This node identification can, for example be achieved by a user placing a probe on each leg or pin of the component sequentially. Furthermore, if component identifiers are present the self-learn method can be used to generate tests for specific components specified by the user, since the node information adjacent the component is known and thus by entering the component identifier the system will only test those relevant nodes.

## Claims

1. A self-learn method for a circuit tester comprising the steps of:
- setting every node (A,B,C,D) of a circuit to a common potential;
- removing the common potential from a first chosen stimulus node (A) and applying a stimulus voltage to said first chosen stimulus node (A) and removing the common potential from a second chosen test node (B);
- monitoring the voltage developed on the second chosen test node (B);
- identifying the presence of a component between the first and second nodes by means of the variation of the voltage developed at the second chosen test node (B) with time, and
- repeating the process for at least a portion of all pairs of nodes on the circuit.

2. A self-learn method as claimed in claim 1, wherein each node (A,B,C,D) on the circuit is tested against each other node, using each node as a stimulus node and a test node so that every possible pair of nodes is tested twice.

3. A self-learn method as claimed in claim 1 or claim 2, wherein the common potential is ground potential.

4. A self-learn method as claimed in any of the preceding claims, wherein the first (A) and second (B) nodes are discharged prior to applying the stimulus voltage.

5. A self-learn method as claimed in any of the preceding claims, wherein the voltage developed at the second node (B) is monitored over a chosen time period.

6. A self-learn method as claimed in any of the preceding claims, wherein the voltage developed on the test node (B) is compared with a chosen threshold value.

7. A self-learn method as claimed in claim 6, wherein the test on one pair of nodes is terminated if the monitored voltage crosses the threshold value from a chosen direction, and the test on a subsequent pair of nodes is then initiated.

8. A self-learn method as claimed in claim 6 or claim 7, wherein the stimulus voltage is 1V and the threshold value is 20mV.

## Patentansprüche

1. Ein Selbstlernverfahren für ein Schaltkreisprüfgerät mit den Schritten:
- Einstellen jedes Knotenpunktes (A, B, C, D) eines Schaltkreises auf ein gemeinsames Potential;
- Entfernen des gemeinsamen Potentials von einem ersten ausgewählten Anregungknotenpunkt (A) und Anlegen einer Anregungsspannung an den zuerst ausgewählten Anregungsknotenpunkt (A) und Entfernen des gemeinsamen Potentials von einem zweiten ausgewählten Prüfknotenpunkt (B);
- Überwachen der an dem zweiten gewählten Prüfknotenpunkt (B) aufgebauten Spannung;
- Identifizieren des Vorhandenseins eines Bauelementes zwischen den ersten und zweiten Knotenpunkten mittels der zeitlichen Änderung der an dem zweiten ausgewählten Prüfknotenpunkt (B) aufgebauten Spannung, und
- Wiederholen des Prozesses bei wenigstens einem Teil aller Knotenpunktpaare auf dem Schaltkreis.

2. Selbstlernverfahren nach Anspruch 1,
wobei jeder Knotenpunkt (A, B, C, D) auf dem Schaltkreis gegen jeden anderen Knotenpunktes geprüft wird, wobei jeder Knotenpunkt als ein Anregungsknotenpunkt und ein Prüfknotenpunkt benutzt wird, so daß jedes mögliche Paar von Knotenpunkten zweifach geprüft wird.

3. Selbstlernverfahren nach Anspruch 1 oder 2,
wobei das gemeinsame Potential das Erdpotential ist.

4. Selbstlernverfahren nach einem der vorhergehenden Ansprüche,
wobei die ersten (A) und zweiten (B) Knotenpukte vor dem Anlegen der Anregungsspannung entladen werden.

5. Selbstlernverfahren nach einem der vorhergehenden Ansprüche,
wobei die am zweiten Knotenpunkt (B) aufgebaute Spannung über ein gewähltes Zeitintervall überwacht wird.

6. Selbstlernverfahren nach irgendeinem der vorhergehenden Ansprüche,
wobei die an dem Prüfknotenpunkt (B) aufgebaute Spannung mit einem gewählten Schwellenwert verglichen wird.

7. Selbstlernverfahren nach Anspruch 6,
wobei die Prüfung an einem Knotenpunktpaar beendet wird, falls die überwachte Spannung den Schwellenwert von einer gewählten Richtung kreuzt, und dann die Prüfung eines nachfolgenden Knotenpunktpaares eingeleitet wird.

8. Selbstlernverfahren nach Anspruch 6 oder 7,
wobei die Anregungsspannung 1 V beträgt und der Schwellenwert 20 mV beträgt.

## Revendications

1. Procédé d'apprentissage auto-adaptatif pour appareil de contrôle de circuits, comprenant les opérations suivantes:
- mettre chacun des noeuds (A, B, C, D) d'un circuit à un potentiel commun;
- supprimer le potentiel commun sur un premier noeud (A), choisi comme noeud de stimulus, appliquer audit premier noeud de stimulus choisi (A) une tension de stimulus, et supprimer le potentiel commun sur un deuxième noeud (B), choisi comme point de mesure;
- relever la tension qui s'est établie sur le deuxième noeud (B) choisi comme point de mesure;
- identifier la présence d'un composant entre les premier et deuxième noeuds grâce à la variation, en fonction du temps, de la tension qui s'est établie sur le deuxième noeud (B) choisi comme point de mesure; et
- répéter l'opération pour au moins une partie de toutes les paires de noeuds du circuit.

2. Procédé d'apprentissage auto-adaptatif selon la revendication 1, où on contrôle chaque noeud (A, B, C, D) du circuit par rapport à chacun des autres noeuds, en utilisant chaque noeud comme noeud de stimulus et comme noeud de mesure, de sorte que toute paire de noeuds possible est contrôlée deux fois.

3. Procédé d'apprentissage auto-adaptatif selon la revendication 1 ou 2, où le potentiel commun est le potentiel de la terre.

4. Procédé d'apprentissage auto-adaptatif selon l'une quelconque des revendications précédentes, où on fait décharger le premier noeud (A) et le deuxième noeud (B) avant d'appliquer la tension de stimulus.

5. Procédé d'apprentissage auto-adaptatif selon l'une quelconque des revendications précédentes, où on relève la tension qui s'est établie sur le deuxième noeud (B) pendant une durée choisie.

6. Procédé d'apprentissage auto-adaptatif selon l'une quelconque des revendications précédentes, où on compare la tension établie sur le noeud de mesure (B) avec une valeur de seuil choisie.

7. Procédé d'apprentissage auto-adaptatif selon la revendication 6, où il est mis fin au contrôle d'une paire de noeuds si la tension relevée passe par la valeur de seuil en venant d'une direction choisie, après quoi le contrôle d'une paire de noeuds suivante commence.

8. Procédé d'apprentissage selon la revendication 6 ou 7, où la tension de stimulus est de 1 V et la valeur de seuil est de 20 mV.
